# EUROPEAN PATENT APPLICATION

(11) **EP 4 818 517 A1**
(43) Date of publication of application: **07.10.2026**
(21) Application number: 24896712.7
(22) Date of filing: 29.11.2024
(51) Int. Cl.: F03D 80/60

(54) **WIND TURBINE GENERATOR SET COOLING SYSTEM, METHOD, AND APPARATUS**

(30) Priority: 30.11.2023 CN 202311641048
(71) Applicant: GOLDWIND SCIENCE & TECHNOLOGY CO., LTD., Xinjiang 830026 (CN)
(72) Inventor: WANG, Liheng, Beijing 100176 (CN); ZHANG, Jingyi, Beijing 100176 (CN); LIU, Qingjian, Beijing 100176 (CN)
(74) Representative: Hoffmann Eitle
(86) International application number: PCT/CN2024/135636
(87) International publication number: WO 2025/113630

(57) **Abstract**

A wind turbine generator set cooling system, method, and apparatus, the cooling system comprising a cooling loop (10). The cooling loop (10) comprises a cooling pump station (101), a cooling medium (102), a connecting assembly (103) and at least one cooling branch (104). The connecting assembly (103) is connected between the cooling pump station (101) and the cooling branch (104). The cooling pump station (101) drives the cooling medium (102) to circulate in the cooling loop (10). The cooling branch (104) comprises a number N of heat exchange assemblies (1041) connected in series, N being an integer greater than or equal to 2. An outlet of the cooling pump station (101) is separately connected to an inlet of each cooling branch (104), and an inlet of the cooling pump station (101) is separately connected to an outlet of each cooling branch (104). The multiple heat exchange assemblies are connected in series, which can reduce the number of parts, decrease costs, and increase economic efficiency.

## Description

### CROSS-REFERENCE TO RELATED APPLICATIONS

The present application claims priority to Chinese Patent Application No. 202311641048.6, filed on November 30, 2023, the entire content of which is incorporated herein by reference.

### TECHNICAL FIELD

The present application relates to the technical field of wind power generation, and in particular, to a cooling system for a wind turbine generator system, a cooling method for a wind turbine generator system, and a cooling apparatus for a wind turbine generator system.

### BACKGROUND

With the development of wind turbine generator systems, the single-unit capacity of a wind turbine generator system continues to increase, and the heat generation of the wind turbine generator system also increases accordingly. In order to ensure normal and efficient operation of the wind turbine generator system, it is necessary to cool heat-generating components such as a generator, a converter, and a gearbox.

Currently adopted cooling schemes have a relatively high cost when cooling components such as the generator, the converter, and the gearbox.

### SUMMARY

Embodiments of the present application provide a cooling system for a wind turbine generator system, a cooling method for a wind turbine generator system, and a cooling apparatus for a wind turbine generator system, which can reduce the cooling cost of the wind turbine generator system.

In a first aspect, an embodiment of the present application provides a cooling system for a wind turbine generator system, comprising a cooling circuit. The cooling circuit comprises a cooling pump station, a cooling medium, a connection assembly, and at least one cooling branch. The connection assembly is in fluid communication between the cooling pump station and the at least one cooling branch. The cooling pump station drives the cooling medium to circulate in the cooling circuit. The at least one cooling branch comprises N heat exchange assemblies connected in series, where N is an integer greater than or equal to 2,
wherein an outlet of the cooling pump station is connected to an inlet of each of the at least one cooling branch, and an inlet of the cooling pump station is connected to an outlet of each of the at least one cooling branch.

In a second aspect, an embodiment of the present application provides a cooling method for a wind turbine generator system, applied to the cooling system for the wind turbine generator system according to the first aspect. The cooling method comprises:
acquiring a first outlet temperature of a cooling pump station and a temperature difference of a target heat exchange assembly while the cooling pump station is operating at a first frequency, wherein the target heat exchange assembly is at least one of the N heat exchange assemblies, and the temperature difference is a difference between an outlet temperature and an inlet temperature of the target heat exchange assembly; and
performing variable-frequency control on the cooling pump station according to at least one of the first outlet temperature or the temperature difference.

In a third aspect, an embodiment of the present application provides a cooling apparatus for a wind turbine generator system. The cooling apparatus comprises:
an acquisition module, configured to acquire a first outlet temperature of a cooling pump station and a temperature difference of a target heat exchange assembly while the cooling pump station is operating at the first frequency, wherein the target heat exchange assembly is at least one of the N heat exchange assemblies, and the temperature difference is a difference between an outlet temperature and an inlet temperature of the target heat exchange assembly; and
a control module, configured to perform variable-frequency control on the cooling pump station according to at least one of the first outlet temperature or the temperature difference.

In a fourth aspect, an embodiment of the present application provides an electronic device, comprising:
a processor; and
a memory, configured to store computer program instructions,
wherein when the computer program instructions are executed by the processor, the method according to the second aspect is implemented.

In a fifth aspect, an embodiment of the present application provides a computer-readable storage medium, storing computer program instructions thereon, wherein when the computer program instructions are executed by a processor, the method according to the second aspect is implemented.

The cooling system of the embodiments of the present application comprises a cooling circuit. The cooling circuit comprises a cooling pump station, a cooling medium, a connection assembly, and at least one cooling branch. The connection assembly is in fluid communication between the cooling pump station and the at least one cooling branch. The cooling pump station drives the cooling medium to circulate in the cooling circuit. The at least one cooling branch comprises N heat exchange assemblies connected in series, where N is an integer greater than or equal to 2, wherein the outlet of the cooling pump station is connected to the inlet of each of the at least one cooling branch, and the inlet of the cooling pump station is connected to the outlet of each of the at least one cooling branch. That is, when designing the cooling system, the embodiments of the present application connect a plurality of heat exchange assemblies in series, which can thereby reduce the number of components, reduce cost, and improve economy.

### BRIEF DESCRIPTION OF THE DRAWINGS

Features, advantages, and technical effects of exemplary embodiments of the present application will be described below with reference to the drawings.
FIG. 1 is a structural diagram of a cooling system for a wind turbine generator system provided by an embodiment of the present application;
FIG. 2 is another structural diagram of a cooling system for a wind turbine generator system provided by an embodiment of the present application;
FIG. 3 is yet another structural diagram of a cooling system for a wind turbine generator system provided by an embodiment of the present application;
FIG. 4 is a flowchart of a cooling method for a wind turbine generator system provided by an embodiment of the present application;
FIG. 5 is a schematic diagram of a variable-frequency control process of a cooling pump provided by an embodiment of the present application;
FIG. 6 is a schematic diagram of a determination process for enhanced cooling provided by an embodiment of the present application;
FIG. 7 is a schematic diagram of variable-frequency control based on enhanced cooling provided by an embodiment of the present application;
FIG. 8 is a schematic diagram of variable-frequency control after a heater is started provided by an embodiment of the present application;
FIG. 9 is a structural diagram of a cooling apparatus for a wind turbine generator system provided by an embodiment of the present application; and
FIG. 10 is a structural diagram of an electronic device provided by an embodiment of the present application.

### DETAILED DESCRIPTION

The features and exemplary embodiments of various aspects of the present application will be described in detail below. In the following detailed description, numerous specific details are set forth in order to provide a thorough understanding of the present application. However, it will be apparent to those skilled in the art that the present application may be practiced without some of these specific details. The following description of the embodiments is merely to provide a better understanding of the present application by showing examples of the present application. In the drawings and the following description, at least some of well-known structures and techniques are not shown in order to avoid unnecessarily obscuring the present application; and, for clarity, dimensions of some structures may be exaggerated. Furthermore, the features, structures, or characteristics described below may be combined in any suitable manner in one or more embodiments.

The directional terms appearing in the following description refer to the directions shown in the drawings, and are not intended to limit specific structures of a guyed tower and a wind turbine generator system of the present application. In the description of the present application, it should also be noted that, unless otherwise clearly specified and limited, the terms "mounted" and "connected" should be understood in a broad sense. For example, it may be a fixed connection, a detachable connection, or an integral connection; it may be a direct connection or an indirect connection. For those skilled in the art, specific meanings of the above terms in the present application can be understood according to specific situations.

In the related art, when cooling a wind turbine generator system, a cooling system is usually designed for each heat-generating component, and the cooling systems of the heat-generating components are independent of each other.

For example, for heat-generating components such as a generator, a converter, and a gearbox, it is necessary to design a cooling system for the generator, a cooling system for the converter, and a cooling system for the gearbox, and the three cooling systems are independent of each other. As a result, a large number of components are required, resulting in a relatively high cost.

To this end, embodiments of the present application provide a cooling system for a wind turbine generator system, a cooling method for a wind turbine generator system, and a cooling apparatus for a wind turbine generator system, which can reduce the cooling cost of the wind turbine generator system.

Hereinafter, the cooling system for a wind turbine generator system, the cooling method for a wind turbine generator system, and the cooling apparatus for the wind turbine generator system provided by the embodiments of the present application will be described in detail through specific embodiments.

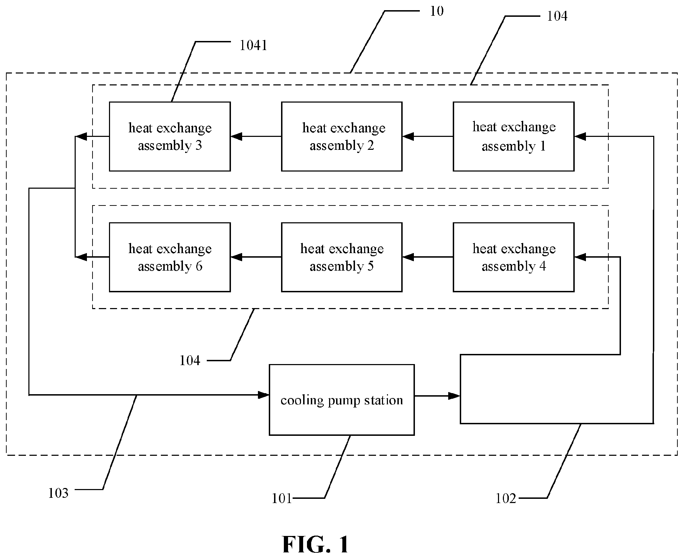

FIG. 1 is a structural diagram of a cooling system for a wind turbine generator system provided by an embodiment of the present application. As shown in FIG. 1, the cooling system for the wind turbine generator system comprises a cooling circuit 10. The cooling circuit 10 comprises a cooling pump station 101, a cooling medium 102, a connection assembly 103, and at least one cooling branch 104. In some embodiments, in a case that a plurality of cooling branches 104 are included, the plurality of cooling branches 104 may be connected in parallel.

The cooling pump station 101 drives the cooling medium 102 to circulate in the cooling circuit 10. During the circulation, the cooling medium 102 can carry away heat from a heat-generating component, thereby achieving cooling of the heat-generating component.

An outlet of the cooling pump station 101 is connected to an inlet of each of the cooling branches 104, and an inlet of the cooling pump station 101 is connected to an outlet of each of the cooling branches 104. That is, in the embodiments of the present application, the cooling branches 104 are connected in parallel, which can improve the cooling efficiency of the wind turbine generator system.

Exemplarily, the cooling pump station 101 may comprise a mechanical pump. The heat-generating components may include, but is not limited to, a gearbox, a generator, a transformer, a converter, etc.

The cooling medium 102 may be water or other cooling liquids, which is not limited in the embodiments of the present application.

The connection assembly 103 is in fluid communication between the cooling pump station 101 and the at least one cooling branch 104, so that the cooling medium 102 can circulate in the cooling circuit 10 to achieve cooling. Exemplarily, the connection assembly 103 may be detachably connected to the cooling pump station 101 and the at least one cooling branch 104, for example, through a mechanical threaded connection, which facilitates replacement when the connection assembly 103 is abnormal.

A cooling branch 104 comprises a plurality of heat exchange assemblies 1041 connected in series. FIG. 1 illustrates an example in which two cooling branches 104 are included and each cooling branch 104 comprises three heat exchange assemblies 1041. In practical applications, the number of cooling branches 104 and the number of heat exchange assemblies 1041 on each cooling branch 104 can be adjusted according to the number of heat exchange assemblies and requirements.

A heat exchange assembly 1041 is configured to transfer heat generated by a heat-generating component to the cooling medium 102, so as to cool the corresponding heat-generating component. Exemplarily, one heat-generating component may include one or more heat exchange assemblies 1041.

Exemplarily, when the same heat-generating component includes a plurality of heat exchange assemblies 1041, the respective heat exchange assemblies 1041 may be separately disposed in different cooling branches 104, thereby improving the cooling efficiency.

The number of the heat exchange assemblies 1041 included in each of the cooling branches 104 may be the same or different. FIG. 1 illustrates an example in which each cooling branch 104 includes the same number of heat exchange assemblies 1041.

Exemplarily, different heat exchange assemblies 1041 in the same cooling branch 104 may correspond to different heat-generating components. For example, a heat-generating component corresponding to a heat exchange assembly 1 may be a generator, a heat-generating component corresponding to a heat exchange assembly 2 may be a converter, and a heat-generating component corresponding to a heat exchange assembly 3 may be a transformer.

Exemplarily, heat-generating components corresponding to the heat exchange assemblies 1041 in each cooling branch 104 may be the same. For example, a heat exchange assembly 1 and a heat exchange assembly 4 correspond to a heat-generating component A, a heat exchange assembly 2 and a heat exchange assembly 5 correspond to a heat-generating component B, and a heat exchange assembly 3 and a heat exchange assembly 6 correspond to a heat-generating component C. The heat-generating component A, the heat-generating component B, and the heat-generating component C may be different.

Compared with a traditional scheme of designing an independent cooling system for each heat-generating component, the embodiments of the present application connect the heat exchange assemblies 1041 of the plurality of heat-generating components in series, which can not only reduce the number of components required to cool the heat-generating components, reduce cost, and improve economy, but also simultaneously cool the heat-generating components. Meanwhile, providing the plurality of heat exchange assemblies 1041 on different cooling branches 104 can improve the cooling efficiency.

In some embodiments, a cooling order of the heat exchange assemblies may be determined according to at least one of a thermal property or operating conditions of a heat-generating component corresponding to each heat exchange assembly.

That is, an order of the heat exchange assemblies 1041 on the cooling branch 104 in FIG. 1 (that is, a cooling order of the corresponding heat-generating components) is determined according to at least one of the thermal property or the operating conditions of the heat-generating component corresponding to each heat exchange assembly 1041.

The thermal property may include a specific heat of the heat-generating component, and the specific heat is configured to characterize a sensitivity of the heat-generating component to a temperature change. For example, a larger specific heat of the heat-generating component indicates a lower sensitivity to the temperature change.

The operating conditions of the heat-generating component may be a temperature required for the heat-generating component to operate normally. For example, it may include a minimum inlet temperature and a maximum inlet temperature of the cooling medium 102 allowed by each heat-generating component.

Based on the thermal property and/or the operating conditions of the heat-generating component, the cooling order of each heat-generating component can be determined to improve economy.

Taking the thermal property including the specific heat as an example, exemplarily, assuming that specific heats of heat-generating components corresponding to a heat exchange assembly 1, a heat exchange assembly 2, and a heat exchange assembly 3 sequentially increase, the respective heat-generating components can be cooled in an order of first cooling the heat-generating component corresponding to the heat exchange assembly 1, then cooling the heat-generating component corresponding to the heat exchange assembly 2, and finally cooling the heat-generating component corresponding to the heat exchange assembly 3. In this way, the amount of material used for temperature reduction of the heat-generating component having a small specific heat can be reduced, and the cost is lowered.

For example, for a generator, a converter, and a transformer, since sensitivities of the generator, the converter, and the transformer to temperature changes sequentially decrease, when cooling the generator, the converter, and the transformer, cooling can be performed in the order of the generator first, then the converter, and finally the transformer.

Based on the thermal property and/or the operating conditions of the heat-generating component, the cooling order of each heat-generating component is determined in the embodiments of the present application, which can reduce cost and improve economy.

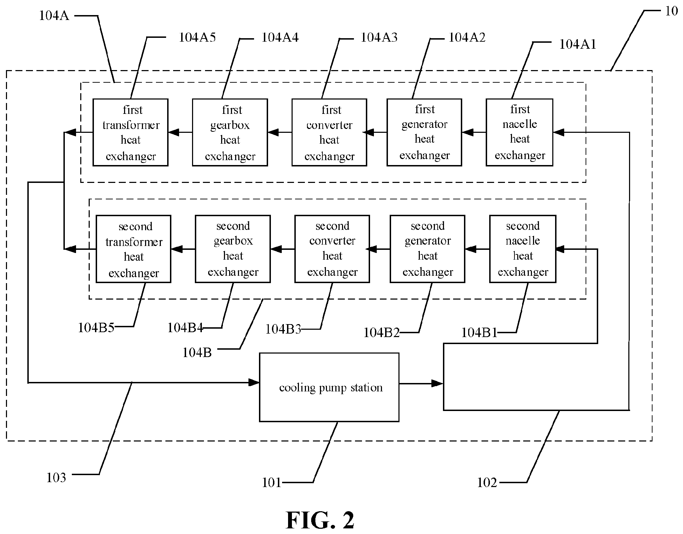

As shown in FIG. 2, an example is taken in which the cooling branches 104 include two cooling branches, namely a first cooling branch 104A and a second cooling branch 104B, and in which a gearbox, a generator, a converter, a transformer, and a nacelle environment of a wind turbine generator system are cooled. In practical applications, two nacelle heat exchangers are usually arranged in the nacelle. Similarly, the generator, the converter, the transformer, and the gearbox are also usually equipped with two heat exchangers to improve cooling efficiency.

Based on the above considerations, exemplarily, referring to FIG. 2, the first cooling branch 104A comprises a first nacelle heat exchanger 104A1, a first generator heat exchanger 104A2, a first converter heat exchanger 104A3, a first gearbox heat exchanger 104A4, and a first transformer heat exchanger 104A5 which are sequentially connected in series;

The second cooling branch 104B comprises a second nacelle heat exchanger 104B1, a second generator heat exchanger 104B2, a second converter heat exchanger 104B3, a second gearbox heat exchanger 104B4, and a second transformer heat exchanger 104B5 which are sequentially connected in series.

The outlet of the cooling pump station 101 is connected to an inlet of the first nacelle heat exchanger 104A1 and an inlet of the second nacelle heat exchanger 104B1, and the inlet of the cooling pump station 101 is connected to an outlet of the first transformer heat exchanger 104A5 and an outlet of the second transformer heat exchanger 104B5.

The first nacelle heat exchanger 104A1 and the second nacelle heat exchanger 104B1 are configured to cool the nacelle environment; the first generator heat exchanger 104A2 and the second generator heat exchanger 104B2 are configured to cool a casing and a water jacket of the generator, respectively; the first converter heat exchanger 104A3 and the second converter heat exchanger 104B3 are configured to cool the converter; the first gearbox heat exchanger 104A4 and the second gearbox heat exchanger 104B4 are configured to cool the gearbox; and the first transformer heat exchanger 104A5 and the second transformer heat exchanger 104B5 are configured to cool the transformer.

Since the nacelle environment dissipates less heat than the generator, the converter, the gearbox, and the transformer, and specific heats of the generator, the converter, the gearbox, and the transformer sequentially increase, that is, sensitivities to temperature changes sequentially decrease, first cooling the nacelle environment yields the cooling medium 102 with a relatively low temperature, and then cooling the generator can reduce the use of active materials of the generator, thereby reducing the cooling cost. Subsequently, separately cooling the converter, the gearbox, and the transformer can not only achieve a cooling effect, but also, since sensitivities of the converter, the gearbox, and the transformer to temperature changes sequentially decrease, allow the converter, the gearbox, and the transformer to operate normally as the temperature of the cooling medium 102 rises.

The embodiments of the present application adopt a series-connection arrangement to sequentially cool the nacelle environment, the generator, the converter, the gearbox, and the transformer, which can not only reduce the number of components required to cool the heat-generating components and reduce the cost, but also simultaneously cool heat-generating components such as the nacelle environment and the generator. Meanwhile, taking into account a characteristic that two nacelle heat exchangers are arranged in the nacelle, and other heat-generating components are also usually equipped with two heat exchangers, two heat exchangers of the same heat-generating component are respectively arranged on different branches to obtain two parallel branches, which improves the cooling efficiency. That is, the embodiments of the present application adopt a combination of a series connection and a parallel connection to design a cooling system, which reduces the cooling cost while improving the cooling efficiency.

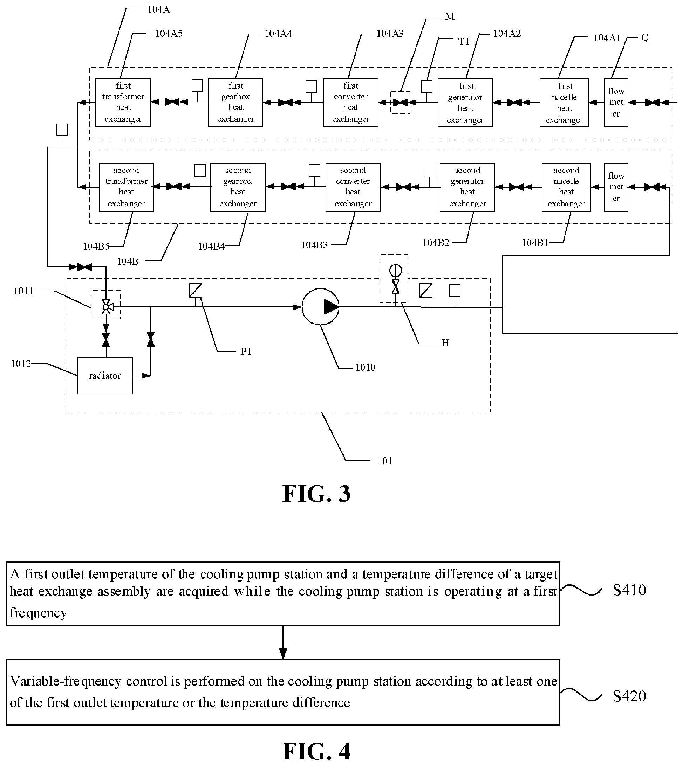

In some embodiments, as shown in FIG. 3, the cooling pump station 101 may comprise a cooling pump 1010, a three-way valve 1011, and a radiator 1012;

An inlet of the three-way valve 1011 is connected to the outlet of each of the cooling branches 104, a first outlet of the three-way valve 1011 is connected to an inlet of the radiator 1012, and an outlet of the radiator 1012 and a second outlet of the three-way valve 1011 are each connected to an inlet of the cooling pump 1010.

Exemplarily, the three-way valve 1011 may be an electric three-way valve. When each heat-generating component needs to be cooled, the inlet of the three-way valve 1011 can be controlled to communicate with the first outlet, so that the cooling medium 102 in the cooling circuit 10 passes through the three-way valve 1011 and can reach the radiator 1012. After dissipating heat through the radiator 1012, the cooling medium 102 with a low temperature returns to the cooling pump 1010 and enters the next circulation, thereby achieving cooling. When the inlet of the three-way valve 1011 communicates with the first outlet, it is also referred to as the cooling circuit 10 being switched to an external circulation circuit.

Exemplarily, in some scenarios, the converter requires heating. At this time, the inlet of the three-way valve 1011 can be controlled to communicate with the second outlet, so that the cooling medium 102 in the cooling circuit 10 passes through the three-way valve 1011 and can directly return to the cooling pump 1010 without passing through the radiator 1012, thereby avoiding a temperature decrease of the cooling medium 102. When the inlet of the three-way valve 1011 communicates with the second outlet, it is also referred to as the cooling circuit 10 being switched to an internal circulation circuit.

The embodiments of the present application do not limit the type, material, and structure of the radiator 1012, and any radiator 1012 capable of lowering the temperature of a cooling medium can be applied to the embodiments of the present application. For example, the radiator 1012 may be an air-cooled radiator, a water-cooled radiator, etc.

By controlling a communication relationship between the inlet and the two outlets of the three-way valve, the embodiments of the present application can achieve both cooling and heating, thus being applicable to more scenarios, and cooling of an entire wind turbine generator system is achieved through a single cooling pump, improving integration and reliability of the cooling system.

In some embodiments, as shown in FIG. 3, the cooling circuit 10 may further comprise a temperature sensor TT, a pressure sensor PT, a heater H, a butterfly valve M, a flow meter Q, etc. FIG. 3 merely exemplarily lists some components in the cooling circuit 10, and in practical applications, adjustments can also be made according to requirements.

The temperature sensor TT is configured to monitor a temperature. For example, a temperature sensor TT may be disposed at an outlet of each heat exchanger, thereby enabling real-time monitoring of an outlet temperature of each heat exchanger to discover an abnormality in time.

The pressure sensor PT is configured to monitor a pressure. For example, a pressure sensor PT may be disposed at the inlet and the outlet of the cooling pump 1010 to monitor an inlet pressure and an outlet pressure of the cooling pump 1010 in real time, ensuring that the cooling pump 1010 operates within an allowed pressure range.

The heater H is configured to meet heating requirements of components such as a converter. The flow meter Q is configured to monitor a flow rate of the cooling medium 102 in each cooling branch 104. For example, a flow meter Q may be disposed at an inlet of each cooling branch 104. The butterfly valve M is configured to adjust a flow rate of the cooling medium 102 in the cooling circuit 10. The cooling circuit 10 of the embodiments of the present application is provided with a relatively large number of butterfly valves M, thereby adapting to temperature requirements of different components.

Exemplarily, at a flow rate Q1, if an outlet temperature of a certain heat exchanger monitored based on the temperature sensor TT is relatively high, a butterfly valve M can be adjusted to increase a flow rate of the cooling medium 102, thereby lowering the outlet temperature of the heat exchanger.

The embodiments of the present application comprehensively consider characteristics such as thermal properties and operating conditions of each heat-generating component, and in view of a characteristic that the same heat-generating component includes a plurality of heat exchange assemblies, adopt a combination of a series connection and a parallel connection to design a cooling system. This reduces the use of parts, which not only lowers cost, but also avoids a problem of a relatively high failure rate of the cooling system due to the use of an excessive number of components, improving economy and reliability of the entire cooling system.

Based on the above cooling system, an embodiment of the present application further provides a cooling method for a wind turbine generator system, and the method can be applied to the cooling system in any one of the above embodiments.

As shown in FIG. 4, the cooling method may comprise the following steps.

In S410: a first outlet temperature of a cooling pump station and a temperature difference of a target heat exchange assembly are acquired while the cooling pump station is operating at the first frequency.

The target heat exchange assembly is at least one of N heat exchange assemblies, and the temperature difference is a difference between an outlet temperature and an inlet temperature of the target heat exchange assembly.

In S420: Variable-frequency control is performed on the cooling pump station according to at least one of the first outlet temperature or the temperature difference.

The above steps will be described in detail below, as follows:

In S410, exemplarily, the first frequency may be an initial operating frequency of the cooling pump, or an operating frequency adopted by the cooling pump when no heating request from the converter is received. Exemplarily, the first frequency may be 50% of the rated frequency. For convenience of description, the embodiments of the present application denote 50% of the rated frequency as a 50% frequency. Initially, controlling the cooling pump to start at a relatively low frequency can reduce an impact of a cooling medium on the cooling pump, providing a protective effect on the cooling pump.

The first outlet temperature is an outlet temperature of the cooling pump station, that is, an outlet temperature of the cooling pump, and the outlet temperature can be measured by a temperature sensor disposed at an outlet of the cooling pump.

The target heat exchange assembly may be at least one of the N heat exchange assemblies. For example, the target heat exchange assembly may include, but is not limited to, a heat exchange assembly of a heat-generating component such as a converter, a generator, a gearbox, etc.

The temperature difference of the target heat exchange assembly is a difference between the outlet temperature and the inlet temperature of the target heat exchange assembly. The outlet temperature of the target heat exchange assembly can be measured by a temperature sensor disposed at an outlet of the target heat exchange assembly. The inlet temperature of the target heat exchange assembly is an outlet temperature of a preceding heat exchange assembly; therefore, the inlet temperature of the target heat exchange assembly can be measured by a temperature sensor disposed at an outlet of the preceding heat exchange assembly.

Exemplarily, a first outlet temperature of the cooling pump, and an inlet temperature and an outlet temperature of the target heat exchange assembly at this time can be acquired through temperature sensors while the cooling pump is operating at the first frequency, providing a temperature basis for subsequently executing a variable-frequency control strategy on the cooling pump.

In S420, according to the first outlet temperature of the cooling pump and/or the temperature difference of the target heat exchange assembly, variable-frequency control can be performed on the cooling pump station, which can improve economy.

Exemplarily, when the first outlet temperature of the cooling pump is relatively high, an operating frequency of the cooling pump can be increased. For example, the operating frequency of the cooling pump can be increased from the first frequency to a second frequency, so as to increase a flow rate of the cooling medium and improve cooling efficiency.

Exemplarily, when the first outlet temperature of the cooling pump is relatively low and the temperature difference of the target heat exchange assembly is relatively small, the operating frequency of the cooling pump can be decreased. For example, the operating frequency of the cooling pump can be decreased from the first frequency to a third frequency, so as to reduce a flow rate of the cooling medium and improve economy.

Based on an outlet temperature of the cooling pump and a temperature difference of the target heat exchange assembly, the embodiments of the present application can flexibly adjust an operating frequency of the cooling pump, thereby realizing variable-frequency control on the cooling pump and improving economy while meeting a temperature requirement.

In some embodiments, the above S420 may comprise the following steps of:
controlling, in response to the first outlet temperature being greater than or equal to a first threshold, the cooling pump station to operate at a second frequency, the second frequency being greater than the first frequency;
controlling, in response to the temperature difference being less than a second threshold and the first outlet temperature being less than a third threshold, the cooling pump station to operate at a third frequency, the third frequency being less than the first frequency.

Magnitudes of the first threshold, the second threshold, and the third threshold can be set according to practical requirements. When the cooling pump operates at different frequencies, the first threshold, the second threshold, and the third threshold may vary. For example, regarding the first threshold, when the cooling pump operates at a 50% frequency, the first threshold may be set to 21°C, and when the cooling pump operates at a 60% frequency, the first threshold may be set to 27°C. The second threshold and the third threshold are similar.

Exemplarily, when the first outlet temperature of the cooling pump is greater than or equal to the first threshold, that is, when the outlet temperature is relatively high, a flow rate of the cooling medium can be increased. That is, at this time, an operating frequency of the cooling pump can be increased. For example, the cooling pump can be controlled to operate at a second frequency, the second frequency being greater than the first frequency.

Exemplarily, when the first outlet temperature of the cooling pump is less than the first threshold, an operating frequency of the cooling pump can be determined by further combining a temperature difference of the target heat exchange assembly.

For example, when the first outlet temperature of the cooling pump is less than the first threshold and the temperature difference of the target heat exchange assembly is greater than or equal to the second threshold, the cooling pump can be controlled to continue operating at the second frequency. When the temperature difference of the target heat exchange assembly is less than the second threshold and the first outlet temperature of the cooling pump is less than the third threshold, an operating frequency of the cooling pump can be decreased. For example, the cooling pump can be controlled to operate at a third frequency, the third frequency being less than the first frequency. Exemplarily, the third threshold is less than the first threshold.

Taking the target heat exchange assembly being a converter heat exchanger as an example, the converter heat exchanger herein may be the first converter heat exchanger in the above embodiment, or may be the second converter heat exchanger. In practical applications, an outlet temperature of the first converter heat exchanger and an outlet temperature of the second converter heat exchanger may be the same, and their inlet temperatures may also be the same.

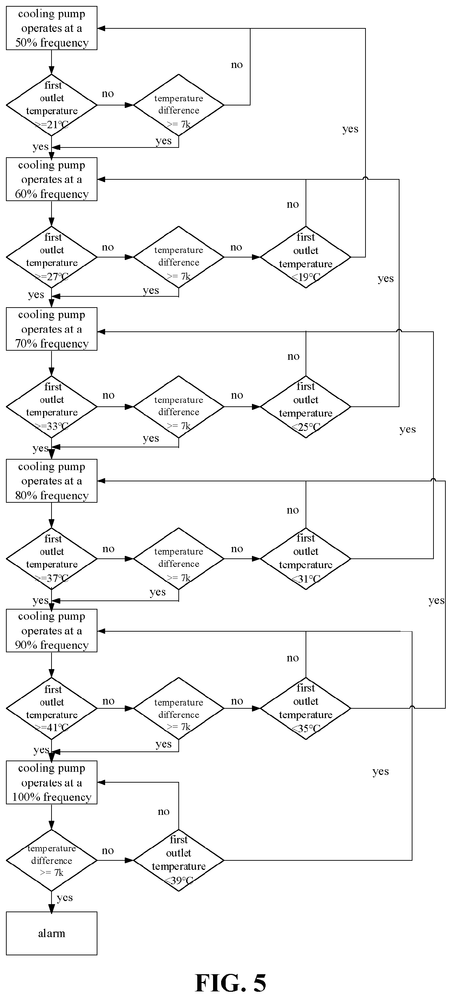

As shown in FIG. 5, assuming that the cooling pump initially operates at a 50% frequency, when a first outlet temperature of the cooling pump is greater than or equal to 21°C (the first threshold), the cooling pump can be controlled to operate at a 60% frequency; when the first outlet temperature of the cooling pump is less than 21°C and a temperature difference of the converter heat exchanger is greater than or equal to 7K (the second threshold), the cooling pump can be controlled to operate at a 60% frequency; when the first outlet temperature of the cooling pump is less than 21°C and the temperature difference of the converter heat exchanger is less than 7K, the cooling pump can be controlled to continue operating at a 50% frequency.

Exemplarily, in a case that the cooling pump operates at a 60% frequency, when a first outlet temperature of the cooling pump is greater than or equal to 27°C (the first threshold), the cooling pump can be controlled to operate at a 70% frequency; when the first outlet temperature of the cooling pump is less than 27°C and a temperature difference of the converter heat exchanger is greater than or equal to 7K (the second threshold), the cooling pump can be controlled to operate at a 70% frequency; when the temperature difference of the converter heat exchanger is less than 7K and the first outlet temperature of the cooling pump is less than 19°C, the cooling pump can be controlled to operate at a 50% frequency; when the temperature difference of the converter heat exchanger is less than 7K and the first outlet temperature of the cooling pump is greater than or equal to 19°C, the cooling pump can be controlled to operate at a 60% frequency.

Exemplarily, in a case that the cooling pump operates at a 70% frequency, when a first outlet temperature of the cooling pump is greater than or equal to 33°C (the first threshold), the cooling pump can be controlled to operate at an 80% frequency; when the first outlet temperature of the cooling pump is less than 33°C and a temperature difference of the converter heat exchanger is greater than or equal to 7K (the second threshold), the cooling pump can be controlled to operate at an 80% frequency; when the temperature difference of the converter heat exchanger is less than 7K and the first outlet temperature of the cooling pump is less than 25°C, the cooling pump can be controlled to operate at a 60% frequency; when the temperature difference of the converter heat exchanger is less than 7K and the first outlet temperature of the cooling pump is greater than or equal to 25°C, the cooling pump can be controlled to operate at a 70% frequency.

Exemplarily, in a case that the cooling pump operates at an 80% frequency, when a first outlet temperature of the cooling pump is greater than or equal to 37°C (the first threshold), the cooling pump can be controlled to operate at a 90% frequency; when the first outlet temperature of the cooling pump is less than 37°C and a temperature difference of the converter heat exchanger is greater than or equal to 7K (the second threshold), the cooling pump can be controlled to operate at a 90% frequency; when the temperature difference of the converter heat exchanger is less than 7K and the first outlet temperature of the cooling pump is less than 31°C, the cooling pump can be controlled to operate at a 70% frequency; when the temperature difference of the converter heat exchanger is less than 7K and the first outlet temperature of the cooling pump is greater than or equal to 31°C, the cooling pump can be controlled to operate at an 80% frequency.

Exemplarily, in a case that the cooling pump operates at a 90% frequency, when a first outlet temperature of the cooling pump is greater than or equal to 41°C (the first threshold), the cooling pump can be controlled to operate at a 100% frequency; when the first outlet temperature of the cooling pump is less than 41°C and a temperature difference of the converter heat exchanger is greater than or equal to 7K (the second threshold), the cooling pump can be controlled to operate at a 100% frequency; when the temperature difference of the converter heat exchanger is less than 7K and the first outlet temperature of the cooling pump is less than 35°C, the cooling pump can be controlled to operate at an 80% frequency; when the temperature difference of the converter heat exchanger is less than 7K and the first outlet temperature of the cooling pump is greater than or equal to 35°C, the cooling pump can be controlled to operate at a 90% frequency.

Exemplarily, in a case that the cooling pump operates at a 100% frequency, when a temperature difference of the converter heat exchanger is less than 7K and a first outlet temperature of the cooling pump is less than 39°C, the cooling pump can be controlled to operate at a 90% frequency; when the temperature difference of the converter heat exchanger is less than 7K and the first outlet temperature of the cooling pump is greater than or equal to 39°C, the cooling pump can be controlled to operate at a 100% frequency. When the temperature difference of the converter heat exchanger is greater than or equal to 7K, an alarm is issued.

By dividing an operating frequency of the cooling pump into several levels such as 50%, 60%, 70%, 80%, 90%, and 100%, fine-grained control of the operating frequency of the cooling pump is achieved, which can further reduce the cooling cost. In practical applications, the operating frequency of the cooling pump may also be divided into other levels, which is not limited in the embodiments of the present application.

The embodiments of the present application can adjust an operating frequency of the cooling pump in real time based on an outlet temperature of the cooling pump and a temperature difference of a target heat exchange assembly, thereby realizing variable-frequency control on the cooling pump, which can reduce auxiliary power consumption of the wind turbine generator system and improve economy.

In some embodiments, the cooling method may further comprise the following steps of:
acquiring a temperature parameter of a target object while the cooling pump is operating at the first frequency, wherein the temperature parameter of the target object includes at least one of a temperature of a generator winding, a temperature rise of the generator winding, an oil pool temperature of a gearbox, a bearing temperature of the gearbox, or an oil temperature of a transformer;

In response to the temperature parameter of the target object satisfying an enhanced cooling condition, controlling the cooling pump station to operate at a fourth frequency, the fourth frequency being greater than the first frequency.

Exemplarily, the target object may be a component with a relatively high temperature or temperature rise. When it is monitored that the temperature or temperature rise of the target object is relatively high, an operating frequency of the cooling pump can be increased to enhance cooling.

Exemplarily, the target object may include, but is not limited to, a winding of a generator, an oil pool and a bearing of a gearbox, and a transformer.

The temperature parameter may include, but is not limited to, a temperature and a temperature rise of the target object. For example, it may include a temperature of a generator winding, a temperature rise of the generator winding, a temperature of an oil pool, a temperature of a bearing, an oil temperature of a transformer, etc.

The temperature of the target object can be measured by a corresponding temperature sensor, and the temperature rise can be determined based on a difference between the temperature of the target object and an ambient temperature.

When the temperature parameter of the target object satisfies an enhanced cooling condition, an enhanced cooling instruction can be generated. Based on the enhanced cooling instruction, an operating frequency of the cooling pump can be increased. For example, the cooling pump can be controlled to operate at a fourth frequency, the fourth frequency being greater than the first frequency. That is, cooling is accelerated by increasing a flow rate of the cooling medium.

Exemplarily, when at least one of a temperature of a generator winding, a temperature rise of the generator winding, an oil pool temperature of a gearbox, a bearing temperature of the gearbox, or an oil temperature of a transformer is abnormal, it is deemed that an enhanced cooling condition is satisfied.

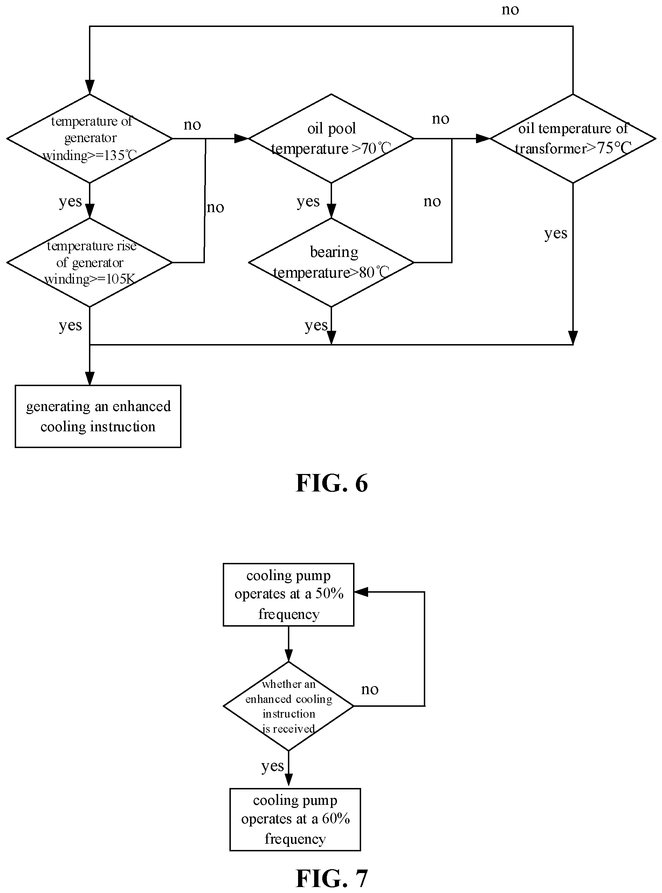

Exemplarily, as shown in FIG. 6, a temperature of a generator winding can be determined first. For example, when the temperature of the generator winding is greater than or equal to 135°C, a temperature rise of the generator winding can be further determined. If the temperature rise of the generator winding is greater than or equal to 105K, it is deemed that an enhanced cooling condition is satisfied, and an enhanced cooling instruction can be generated.

Exemplarily, when a temperature of a generator winding is less than 135°C or a temperature rise of the generator winding is less than 105K, an oil pool temperature of a gearbox can be further determined. When the oil pool temperature of the gearbox is greater than 70°C, if a bearing temperature is greater than 80°C, it is deemed that an enhanced cooling condition is satisfied, and an enhanced cooling instruction can be generated.

When an oil pool temperature of a gearbox is less than or equal to 70°C, or a bearing temperature is less than or equal to 80°C, an oil temperature of a transformer can be further determined. If the oil temperature of the transformer is greater than 75°C, it is deemed that an enhanced cooling condition is satisfied, and an enhanced cooling instruction can be generated. If the oil temperature of the transformer is less than or equal to 75°C, the next cycle can be entered for re-determination.

The above thresholds, such as 135°C, 105K, 70°C, etc., can be adjusted according to practical requirements, and FIG. 6 is merely an example.

Exemplarily, as shown in FIG. 7, when a cooling pump operates at a certain frequency, in addition to determining a first outlet temperature of the cooling pump and a temperature difference of a target heat exchange assembly, it can also be determined whether an enhanced cooling instruction is received. When the enhanced cooling instruction is received, an operating frequency can be increased based on a current frequency; when no enhanced cooling instruction is received, operation at the current frequency can be continued. FIG. 7 takes an example in which the cooling pump operates at a 50% frequency. In practical applications, when the cooling pump operates at a 60% frequency, a 70% frequency, etc., it can also be determined whether an enhanced cooling instruction is received.

In the embodiments of the present application, when the cooling pump station operates at a first frequency, heat-generating components with relatively high temperatures such as a generator winding, an oil pool of a gearbox, a bearing, and an oil pool of a transformer can be monitored in real time, and when at least one abnormality occurs, an operating frequency of the cooling pump is increased in time, ensuring safe and normal operation of the wind turbine generator system.

In some scenarios, a converter may need to be heated. For example, when the converter is restarted after being shut down for a long time, the converter needs to be heated; when a surface of the converter is wet or condensation occurs, the converter needs to be heated.

Exemplarily, when a converter is started, a startup time of the converter can be recorded, and then historical records can be searched to obtain a latest shutdown time of the converter, thereby determining a duration since the last shutdown of the converter. If the duration is greater than a preset duration, a heating request can be sent to a main controller of the wind turbine generator system.

Exemplarily, when it is detected that a surface of a converter is wet or condensation occurs, the converter can send a heating request to a main controller of the wind turbine generator system.

When a heating request is received, a main controller needs to adjust the current control strategy. Based on this, in some embodiments, the cooling method may further comprise the following steps of:
in response to the wind turbine generator system being started, determining whether a heating request of a converter is received;
in response to not receiving the heating request of the converter, controlling the cooling pump station to operate at the first frequency;
in response to receiving the heating request of the converter, acquiring an ambient temperature of the wind turbine generator system at a current moment and an outlet temperature parameter of a generator within a preset duration;
controlling a three-way valve to switch to an internal circulation circuit, the internal circulation circuit being a portion of the cooling circuit excluding a radiator;
performing opening-degree control on the three-way valve according to the ambient temperature and the outlet temperature parameter of the generator within the preset duration, so as to adjust the temperature of a cooling medium in the internal circulation circuit.

Exemplarily, after a wind turbine generator system is started, it can first be determined whether a heating request of a converter is received, to determine a subsequent control strategy.

If no heating request of a converter is received, a cooling pump can be controlled to operate at a first frequency. If a heating request of a converter is received, an inlet of a three-way valve needs to be controlled to communicate with a second outlet, so that a cooling medium flows in an internal circulation circuit to meet a heating requirement.

In an internal circulation circuit, in order to prevent surfaces of components such as a connecting pipeline and a heat exchanger from producing condensation due to a rapid temperature change of a cooling medium forming a relatively large temperature difference with an ambient temperature, which affects their service lives, opening-degree control can be performed on a three-way valve. For example, an opening degree of the three-way valve can be controlled to gradually increase.

Exemplarily, an opening-degree control of a three-way valve can be performed based on an ambient temperature of a wind turbine generator system and an outlet temperature parameter of a generator to adjust an opening degree of the three-way valve in real time.

An outlet temperature parameter of a generator within a preset duration may include, but is not limited to, an outlet temperature of the generator at a current moment and an outlet temperature difference of the generator between the current moment and a moment preceding the current moment.

In the embodiments of the present application, in a case that a wind turbine generator system is started, heating requirements of a converter are fully considered. When no heating request of the converter is received, a cooling pump can be controlled to operate at a first frequency. When a heating request of the converter is received, a three-way valve can be controlled so that a cooling medium flows in an internal circulation circuit. Meanwhile, an opening degree of the three-way valve is controlled based on an ambient temperature of the wind turbine generator system and an outlet temperature parameter of a generator, which can effectively avoid generating condensation on surfaces of components such as a connecting pipeline and a heat exchanger.

Taking an outlet temperature parameter of a generator within a preset duration including a second outlet temperature of the generator at a current moment and an outlet temperature difference of the generator at the current moment and a moment preceding the current moment as an example. Exemplarily, the above "performing opening-degree control on the three-way valve according to the ambient temperature and the outlet temperature parameter of the generator within the preset duration, so as to adjust the temperature of a cooling medium in the internal circulation circuit" may comprise the following steps of:
in response to the ambient temperature being less than a first temperature threshold, the second outlet temperature being greater than a second temperature threshold, and the outlet temperature difference being greater than or equal to a third temperature threshold, controlling the three-way valve to operate at a first opening degree;
in response to the ambient temperature being greater than or equal to the first temperature threshold and less than a fourth temperature threshold, and the outlet temperature difference being greater than or equal to a fifth temperature threshold, controlling the three-way valve to operate at a second opening degree;
in response to the ambient temperature being greater than or equal to the fourth temperature threshold, and the outlet temperature difference being greater than or equal to a sixth temperature threshold, controlling the three-way valve to operate at a third opening degree,
wherein the first opening degree, the second opening degree, and the third opening degree sequentially increase.

Values of the first temperature threshold to the sixth temperature threshold can be set according to practical requirements. Exemplarily, the first temperature threshold may be set to 0°C, the second temperature threshold may be set to 19°C, the third temperature threshold may be set to 0.7°C, the fourth temperature threshold may be set to 20°C, the fifth temperature threshold may be set to 1.4°C, and the sixth temperature threshold may be set to 2°C.

Exemplarily, a determination can be made every two seconds. That is, an outlet temperature of a generator at a current moment and an outlet temperature 2s ago can be collected, and a difference between the outlet temperature at the current moment and the outlet temperature 2s ago is taken as an outlet temperature difference of the generator. Other durations may also be set.

Exemplarily, when an ambient temperature is less than 0°C and an outlet temperature (the second outlet temperature) of a generator at a current moment is greater than 19°C, if an outlet temperature difference of the generator is greater than or equal to 0.7°C, a three-way valve is controlled to operate at a first opening degree.

Exemplarily, when an ambient temperature is greater than or equal to 0°C and less than 20°C, if an outlet temperature difference of a generator is greater than or equal to 1.4°C, an opening degree of a three-way valve is increased. For example, the three-way valve can be controlled to operate at a second opening degree, the second opening degree being greater than a first opening degree.

Exemplarily, when an ambient temperature is greater than 20°C, if an outlet temperature difference of a generator is greater than or equal to 2°C, an opening degree of a three-way valve can be further increased. For example, the three-way valve can be controlled to operate at a third opening degree, the third opening degree being greater than a second opening degree.

Values of the first opening degree, the second opening degree, and the third opening degree can be determined according to practical requirements. Exemplarily, differences between adjacent opening degrees may be the same. For example, a difference between the first opening degree and the second opening degree may be the same as a difference between the second opening degree and the third opening degree. The first opening degree, the second opening degree, and the third opening degree may also be arbitrary, as long as a relationship that the first opening degree, the second opening degree, and the third opening degree sequentially increase is met. Exemplarily, the third opening degree may be a 100% opening degree.

When the temperature of a cooling medium needs to be lowered, an opening degree of a three-way valve can be decreased. Exemplarily, a connection between an inlet of the three-way valve and a second outlet can be directly disconnected, or the opening degree between the inlet of the three-way valve and the second outlet can be gradually decreased.

Taking gradually decreasing an opening degree of a three-way valve as an example, exemplarily, in a case that an ambient temperature is less than a first temperature threshold, a second outlet temperature is less than a seventh temperature threshold, and an outlet temperature difference is less than or equal to an eighth temperature threshold, controlling the three-way valve to operate at a fourth opening degree;

In a case that the ambient temperature is greater than or equal to the first temperature threshold and less than a fourth temperature threshold, and the outlet temperature difference is less than or equal to a ninth temperature threshold, controlling the three-way valve to operate at a fifth opening degree;

In a case that the ambient temperature is greater than or equal to the fourth temperature threshold, and the outlet temperature difference is less than or equal to a tenth temperature threshold, controlling the three-way valve to operate at a sixth opening degree,
wherein the fourth opening degree, the fifth opening degree, and the sixth opening degree sequentially decrease.

Exemplarily, the seventh temperature threshold may be set to 29°C, the eighth temperature threshold may be set to -0.7°C, the ninth temperature threshold may be set to - 1.4°C, and the tenth temperature threshold may be set to -2°C.

That is, when an outlet temperature of a generator is less than 29°C and an outlet temperature difference shows a downward trend, an opening degree of a three-way valve can be gradually decreased to lower a flow rate of a cooling medium and adjust the temperature of the cooling medium.

In the embodiments of the present application, when a cooling circuit is an internal circulation circuit, an opening-degree control can be performed on a three-way valve in combination with an ambient temperature of a wind turbine generator system and an outlet temperature and an outlet temperature difference of a generator. Especially when the outlet temperature difference of the generator shows an upward trend, by performing the opening-degree control on the three-way valve, a temperature of a cooling medium can slowly rise, avoiding generating condensation on surfaces of components such as a connecting pipeline and a heat exchanger due to a rapid temperature rise forming a relatively large deviation from an ambient temperature, which affects their service lives.

In some embodiments, after "performing opening-degree control on the three-way valve according to the ambient temperature and the outlet temperature parameter of the generator within the preset duration, so as to adjust the temperature of a cooling medium in the internal circulation circuit", the cooling method may further comprise the following steps of:
in response to a heater of the cooling pump station being started and the cooling pump station operating at a fifth frequency, performing variable-frequency control on the cooling pump station according to at least one of whether the heating request is eliminated or an outlet temperature of the generator, the fifth frequency being greater than the first frequency.

Exemplarily, after receiving a heating request from a converter, a heater needs to be started to raise the temperature of a cooling medium to meet heating requirements.

After a heater is started, variable-frequency control can be further performed on a cooling pump in combination with whether a heating request of a converter is eliminated and an outlet temperature of a generator, etc., so that an energy consumption of the cooling pump is reduced while meeting requirements of respective components.

Exemplarily, when a heater is initially started, a cooling pump can first be controlled to operate at a 50% frequency and operate for a period of time, for example, 2 min, and then the cooling pump is controlled to operate at a fifth frequency. Exemplarily, the fifth frequency may be a 100% frequency.

Exemplarily, during a period when a cooling pump operates at a 100% frequency, if a heating request of a converter is eliminated, an operating frequency of the cooling pump can be decreased at this time, so that the energy consumption of the cooling pump can be reduced while meeting a requirement of the converter.

Exemplarily, during a period when a cooling pump operates at a 100% frequency, if a heating request of a converter is not eliminated, variable-frequency control can be further performed on the cooling pump in combination with an outlet temperature of a generator.

In the embodiments of the present application, after a heater is started, variable-frequency control can be performed on a cooling pump in combination with whether a heating request of a converter is eliminated and/or an outlet temperature of a generator. While meeting requirements of respective components, the energy consumption of the cooling pump is reduced, and economy is improved.

Exemplarily, the above "performing variable-frequency control on the cooling pump station according to at least one of whether the heating request is eliminated or the outlet temperature of the generator" may comprise the following steps of:
in response to the heating request being eliminated, controlling the heater to be turned off, and switching an operating frequency of the cooling pump station from the fifth frequency to the first frequency;
in response to the heating request not being eliminated and the outlet temperature of the generator being greater than a first threshold, controlling the heater to be turned off, and in response to the outlet temperature of the generator being greater than a second threshold and the heating request being eliminated, switching the operating frequency of the cooling pump station from the fifth frequency to the first frequency.

Exemplarily, if a heating request of a converter is eliminated, a heater can be controlled to be turned off, and simultaneously an operating frequency of a cooling pump is decreased. If the heating request is not eliminated, the heater needs to continue operating. At this time, control strategies of the cooling pump and the heater can be adjusted in combination with an outlet temperature of a generator.

For example, if a heating request is not eliminated, and an outlet temperature of a generator is less than or equal to a first threshold, a heater can continue to be started, and a cooling pump is controlled to continue operating at the current frequency of 100% frequency. If the outlet temperature of the generator is greater than the first threshold, the heater can be controlled to be turned off.

With turning off of a heater, a temperature of a cooling medium in a cooling circuit gradually decreases, that is, an outlet temperature of a generator will decrease accordingly. If the outlet temperature of the generator at this time is less than a second threshold, a cooling pump can be controlled to continue operating at a 100% frequency. If the outlet temperature of the generator at this time is greater than or equal to the second threshold, it can be further determined whether a heating request of a converter is eliminated at this time. If it is eliminated, an operating frequency of the cooling pump can be decreased. For example, the cooling pump can be controlled to operate at a 50% frequency.

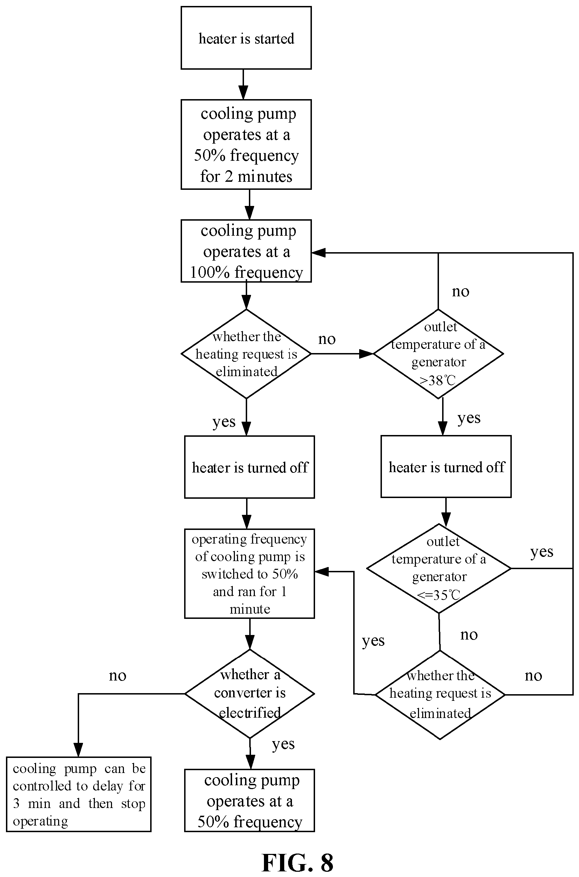

Exemplarily, as shown in FIG. 8, after a heater is started, a cooling pump is controlled to operate at a 50% frequency for 2 min (the duration can be adjusted according to practical requirements), and then the cooling pump is controlled to operate at a 100% frequency.

During a period when a cooling pump operates at a 100% frequency, it can be determined whether a heating request of a converter is eliminated. If the heating request of the converter is eliminated, a heater can be turned off, and an operating frequency of the cooling pump is switched from the 100% frequency to a 50% frequency.

After a cooling pump operates at a 50% frequency for 1 min (the duration can be adjusted according to practical requirements), it can be further determined whether a converter is energized. If the converter is energized, the cooling pump is controlled to continue operating at a 50% frequency. If the converter is not energized, the cooling pump can be controlled to stop operating after a delay of 3 min. Whether it is necessary to continue starting the cooling pump can be subsequently determined as needed.

Exemplarily, as shown in FIG. 8, during a period when a cooling pump operates at a 100% frequency, if a heating request of a converter is not eliminated, it can be determined whether an outlet temperature of a generator is greater than 38°C (a first threshold, which can be adjusted as needed in practical applications).

If an outlet temperature of a generator is less than or equal to 38°C, a cooling pump can be controlled to continue operating at a 100% frequency; if the outlet temperature of the generator is greater than 38°C, a heater can be turned off, and after the heater is turned off, the outlet temperature of the generator is further monitored. If the outlet temperature of the generator is less than or equal to 35°C (a second threshold, which can be adjusted as needed in practical applications), the cooling pump can be controlled to continue operating at a 100% frequency. If the outlet temperature of the generator is greater than 35°C and a heating request of a converter is eliminated, an operating frequency of the cooling pump can be switched from a 100% frequency to a 50% frequency. If the outlet temperature of the generator is greater than 35°C but the heating request of the converter is not eliminated, the cooling pump can be controlled to continue operating at a 100% frequency.

Thereby, variable-frequency control on a cooling pump is achieved. Not only is a heating requirement of a converter met, but also by adjusting an operating frequency of the cooling pump, an energy consumption of the cooling pump is reduced, improving economy.

Exemplarily, during operation of a cooling pump, if it is monitored that a start signal of the cooling pump disappears and/or a wind turbine generator system stops and a converter does not modulate, the cooling pump can be controlled to continue operating for a period of time, such as 15 min, and then stop. If a high/low voltage ride-through and/or an emergency shutdown instruction is monitored, the cooling pump can be controlled to stop immediately, wherein the emergency shutdown instruction can be generated by an emergency stop push-button of a converter being triggered or an emergency stop push-button of a main controller being triggered.

Based on the above cooling system, the embodiments of the present application further combine parameters such as an outlet temperature of a generator and an oil pool temperature of a gearbox to perform variable-frequency control on a cooling pump, reducing an energy consumption of the cooling pump while meeting temperature requirements of respective components. Moreover, when a cooling medium needs to be heated, an opening degree of a three-way valve can be gradually adjusted to prevent surfaces of components such as a connecting pipeline from producing condensation due to a sudden increase in the opening degree, which affects their service lives. In addition, requirements of a converter are also fully considered, and respective components are taken into account, improving an overall performance of a system.

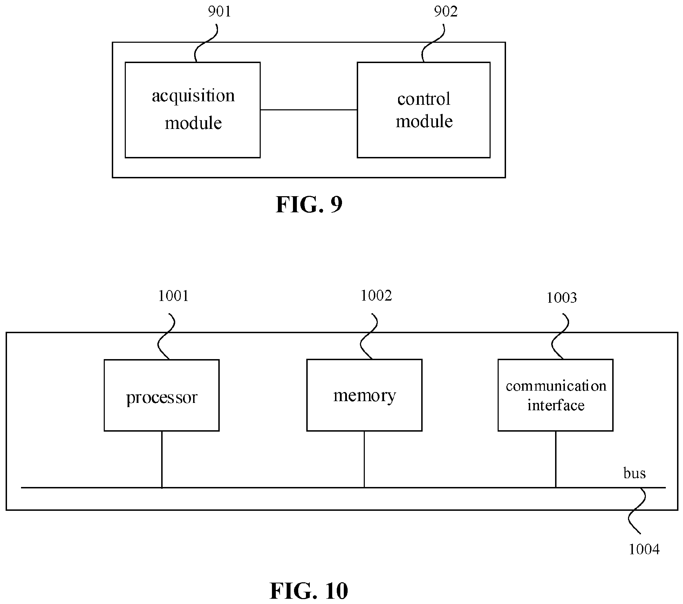

Based on the same inventive concept, an embodiment of the present application further provides a cooling apparatus for a wind turbine generator system. A cooling apparatus for a wind turbine generator system provided by the embodiment of the present application will be described in detail below with reference to FIG. 9.

FIG. 9 is a structural diagram of a cooling apparatus for a wind turbine generator system provided by an embodiment of the present application.

As shown in FIG. 9, the cooling apparatus for the wind turbine generator system may comprise:
an acquisition module 901, configured to acquire a first outlet temperature of a cooling pump station and a temperature difference of a target heat exchange assembly while the cooling pump station is operating at a first frequency, wherein the target heat exchange assembly is at least one of N heat exchange assemblies, and the temperature difference is a difference between an outlet temperature and an inlet temperature of the target heat exchange assembly;
a control module 902, configured to perform variable-frequency control on the cooling pump station according to at least one of the first outlet temperature or the temperature difference.

Based on an outlet temperature of a cooling pump and a temperature difference of a target heat exchange assembly, the embodiments of the present application can flexibly adjust an operating frequency of the cooling pump, achieving variable-frequency control on the cooling pump, and improving economy while meeting a temperature requirement.

In some embodiments, the control module 902 is specifically configured to:
control, in response to the first outlet temperature being greater than or equal to a first threshold, the cooling pump station to operate at a second frequency, the second frequency being greater than the first frequency;
control, in response to the first outlet temperature being less than the first threshold and the temperature difference being greater than or equal to a second threshold, the cooling pump station to operate at the second frequency;
control, in response to the temperature difference being less than the second threshold and the first outlet temperature being less than a third threshold, the cooling pump station to operate at a third frequency, the third frequency being less than the first frequency.

In some embodiments, the acquisition module 901 is further configured to acquire a temperature parameter of a target object while the cooling pump station is operating at the first frequency, wherein the temperature parameter of the target object includes at least one of a temperature of a generator winding, a temperature rise of the generator winding, an oil pool temperature of a gearbox, a bearing temperature of the gearbox, or an oil temperature of a transformer;

The control module 902 is further configured to control, in response to the temperature parameter of the target object satisfying an enhanced cooling condition, the cooling pump station to operate at a fourth frequency, the fourth frequency being greater than the first frequency.

In some embodiments, the cooling apparatus for the wind turbine generator system may further comprise:
a determination module, configured to determine, in response to the wind turbine generator system being started, whether a heating request of a converter is received;
the control module 902 is further configured to control, in response to not receiving the heating request of the converter, the cooling pump station to operate at the first frequency;
the acquisition module 901 is further configured to acquire, in response to receiving the heating request of the converter, an ambient temperature of the wind turbine generator system at a current moment and an outlet temperature parameter of a generator within a preset duration;
the control module 902 is further configured to control a three-way valve to switch to an internal circulation circuit, the internal circulation circuit being a portion of the cooling circuit excluding a radiator;
the control module 902 is further configured to perform opening-degree control on the three-way valve according to the ambient temperature and the outlet temperature parameter of the generator within the preset duration, so as to adjust the temperature of a cooling medium in the internal circulation circuit.

In some embodiments, the outlet temperature parameter of the generator within the preset duration includes a second outlet temperature of the generator at the current moment and an outlet temperature difference of the generator between the current moment and a moment preceding the current moment;

The control module 902 is specifically configured to:
control, in response to the ambient temperature being less than a first temperature threshold, the second outlet temperature being greater than a second temperature threshold, and the outlet temperature difference being greater than or equal to a third temperature threshold, the three-way valve to operate at a first opening degree;
control, in response to the ambient temperature being greater than or equal to the first temperature threshold and less than a fourth temperature threshold, and the outlet temperature difference being greater than or equal to a fifth temperature threshold, the three-way valve to operate at a second opening degree;
control, in response to the ambient temperature being greater than or equal to the fourth temperature threshold, and the outlet temperature difference being greater than or equal to a sixth temperature threshold, the three-way valve to operate at a third opening degree,
wherein the first opening degree, the second opening degree, and the third opening degree sequentially increase.

In some embodiments, the control module 902 is further configured to, after performing the opening-degree control on the three-way valve according to the ambient temperature and the outlet temperature parameter of the generator within the preset duration so as to adjust the temperature of the cooling medium in the internal circulation circuit, in response to a heater of the cooling pump station being started and the cooling pump station operating at a fifth frequency, perform variable-frequency control on the cooling pump station according to at least one of whether the heating request is eliminated or the outlet temperature of the generator, the fifth frequency being greater than the first frequency.

In some embodiments, the control module 902 is specifically configured to:
in response to the heating request being eliminated, control the heater to be turned off, and switch an operating frequency of the cooling pump station from the fifth frequency to the first frequency;
in response to the heating request not being eliminated and the outlet temperature of the generator being greater than a first threshold, control the heater to be turned off, and in response to the outlet temperature of the generator being greater than a second threshold and the heating request being eliminated, switch the operating frequency of the cooling pump station from the fifth frequency to the first frequency.

The cooling apparatus for the wind turbine generator system provided by the embodiments of the present application can realize respective processes in the embodiments of the cooling method for the wind turbine generator system shown in FIG. 4 to FIG. 8, and details are not repeated here to avoid repetition.

Based on the same inventive concept, an embodiment of the present application further provides an electronic device. The electronic device can be, for example, a tablet computer, a notebook computer, a handheld computer, etc. An electronic device provided by an embodiment of the present application will be described in detail below with reference to FIG. 10.

As shown in FIG. 10, the electronic device may comprise a processor 1001 and a memory 1002 configured to store computer program instructions.

The processor 1001 may include a central processing unit (CPU), an application specific integrated circuit (ASIC), or may be configured to implement one or more integrated circuits of the embodiments of the present application.

The memory 1002 may include a mass memory for data or instructions. By way of example, and not limitation, the memory 1002 may include a hard disk drive (HDD), a floppy disk drive, a flash memory, an optical disk, a magneto-optical disk, a magnetic tape, or a universal serial bus (USB) drive, or a combination of two or more of these. In one instance, the memory 1002 may include removable or non-removable (or fixed) media, or the memory 1002 is a non-volatile solid-state memory. In one instance, the memory 1002 may be a read only memory (ROM). In one instance, the ROM may be a mask-programmed ROM, a programmable ROM (PROM), an erasable PROM (EPROM), an electrically erasable PROM (EEPROM), an electrically alterable ROM (EAROM), or a flash memory, or a combination of two or more of these.

The processor 1001 reads and executes the computer program instructions stored in the memory 1002 to implement the methods in the embodiments shown in FIG. 4 to FIG. 8, and achieves the corresponding technical effects of the methods executed by the embodiments shown in FIG. 4 to FIG. 8, which are not repeated here for brevity.

In one example, the electronic device may further comprise a communication interface 1003 and a bus 1004, as shown in FIG. 10, the processor 1001, the memory 1002, and the communication interface 1003 are connected through the bus 1004 and complete communication with each other.

The communication interface 1003 is mainly configured to implement communication between respective modules, apparatuses, and/or devices in the embodiments of the present application.

The bus 1004 includes hardware, software, or both, coupling components of the electronic device to each other. By way of example, and not limitation, the bus 1004 may include an accelerated graphics port (AGP) or other graphics buses, an extended industry standard architecture (EISA) bus, a front side bus (FSB), a hyper transport (HT) interconnect, an industry standard architecture (ISA) bus, an infiniband interconnect, a low pin count (LPC) bus, a memory bus, a micro channel architecture (MCA) bus, a peripheral component interconnect (PCI) bus, a PCI-Express (PCI-X) bus, a serial advanced technology attachment (SATA) bus, a video electronics standards association local (VLB) bus, or other suitable buses, or a combination of two or more of these. Where appropriate, the bus 1004 may include one or more buses. Although the embodiments of the present application describe and show specific buses, the present application contemplates any suitable bus or interconnect.

After acquiring a first outlet temperature of a cooling pump station and a temperature difference of a target heat exchange assembly while the cooling pump station is operating at a first frequency,, the electronic device can execute a cooling method for a wind turbine generator system in the embodiments of the present application, thereby realizing the cooling method for a wind turbine generator system described in combination with FIG. 4 to FIG. 8 and the cooling apparatus for a wind turbine generator system described in FIG. 9.

In addition, in combination with the cooling method for a wind turbine generator system in the above embodiments, an embodiment of the present application can provide a computer storage medium for implementation. The computer storage medium stores computer program instructions; when the computer program instructions are executed by a processor, any one of cooling methods for a wind turbine generator system in the above embodiments is implemented.

It should be clear that the present application is not limited to the specific configurations and processing described above and shown in the figures. For brevity, a detailed description of known methods is omitted here. In the above embodiments, a number of specific steps are described and shown as examples. However, a method process of the present application is not limited to the specific steps described and shown, and those skilled in the art can make various changes, modifications, and additions, or change an order between steps after comprehending the gist of the present application.

Functional blocks shown in the above block diagrams may be implemented as hardware, software, firmware, or a combination thereof. When implemented in hardware, they may be, for example, electronic circuits, application specific integrated circuits (ASICs), appropriate firmware, plug-ins, function cards, etc. When implemented in software, elements of the present application are programs or code segments configured to perform required tasks. The programs or code segments may be stored in a machine-readable medium, or transmitted via a data signal carried in a carrier wave over a transmission medium or communication link. A "machine-readable medium" may include any medium capable of storing or transmitting information. Examples of machine-readable media include an electronic circuit, a semiconductor memory device, a ROM, a flash memory, an erasable ROM (EROM), a floppy disk, a CD-ROM, an optical disk, a hard disk, a fiber optic medium, a radio frequency (RF) link, etc. Code segments may be downloaded via computer networks such as the Internet, an intranet, etc.

It should also be noted that exemplary embodiments mentioned in the present application describe some methods or systems based on a series of steps or apparatuses. However, the present application is not limited to an order of the above steps, that is to say, steps can be executed in an order mentioned in the embodiments, or in an order different from that in the embodiments, or a plurality of steps are executed simultaneously.

Aspects of the embodiments of the present application are described above with reference to flowcharts and/or block diagrams of methods, apparatuses (systems), and computer program products according to the embodiments of the present application. It will be understood that each block of the flowcharts and/or block diagrams, and combinations of blocks in the flowcharts and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, enable the implementation of the functions/acts specified in one or more blocks of the flowcharts and/or block diagrams. Such a processor may be, but is not limited to, a general purpose processor, a special purpose processor, an application specific processor, or a field programmable logic circuit. It will also be understood that each block of the block diagrams and/or flowcharts, and combinations of blocks in the block diagrams and/or flowcharts, can also be implemented by special purpose hardware that performs the specified functions or acts, or can be implemented by a combination of special purpose hardware and computer instructions.

The embodiments of the present application have been described above with reference to the drawings, but the present application is not limited to the specific implementations described above. The specific implementations described above are merely illustrative and not restrictive. Under the teaching of the present application, those skilled in the art can make many forms without departing from the purpose of the present application and a protection scope of the claims, which all fall within the protection of the present application.

## Claims

1. A cooling system for a wind turbine generator system, comprising a cooling circuit, the cooling circuit comprising a cooling pump station, a cooling medium, a connection assembly, and at least one cooling branch, the connection assembly being in fluid communication between the cooling pump station and the at least one cooling branch, the cooling pump station being configured to drive the cooling medium to circulate in the cooling circuit, and the at least one cooling branch comprising N heat exchange assemblies connected in series, where N is an integer greater than or equal to 2,
wherein an outlet of the cooling pump station is connected to an inlet of each of the at least one cooling branch, and an inlet of the cooling pump station is connected to an outlet of each of the at least one cooling branch.

2. The cooling system according to claim 1, wherein a cooling order of the N heat exchange assemblies is determined according to at least one of a thermal property or operating conditions of a heat-generating component corresponding to each of the N heat exchange assemblies.

3. The cooling system according to claim 1 or 2, wherein the at least one cooling branch comprises a first cooling branch and a second cooling branch;
the first cooling branch comprises a first nacelle heat exchanger, a first generator heat exchanger, a first converter heat exchanger, a first gearbox heat exchanger, and a first transformer heat exchanger which are sequentially connected in series;
the second cooling branch comprises a second nacelle heat exchanger, a second generator heat exchanger, a second converter heat exchanger, a second gearbox heat exchanger, and a second transformer heat exchanger which are sequentially connected in series; and
the outlet of the cooling pump station is connected to an inlet of the first nacelle heat exchanger and an inlet of the second nacelle heat exchanger, and the inlet of the cooling pump station is connected to an outlet of the first transformer heat exchanger and an outlet of the second transformer heat exchanger.

4. The cooling system according to claim 1, wherein the cooling pump station comprises a cooling pump, a three-way valve, and a radiator; and
an inlet of the three-way valve is connected to the outlet of each of the at least one cooling branch, a first outlet of the three-way valve is connected to an inlet of the radiator, and an outlet of the radiator and a second outlet of the three-way valve are each connected to the inlet of the cooling pump.

5. A cooling method for a wind turbine generator system, comprising:
acquiring a first outlet temperature of a cooling pump station and a temperature difference of a target heat exchange assembly while the cooling pump station is operating at a first frequency, wherein the target heat exchange assembly is at least one of N heat exchange assemblies, and the temperature difference is a difference between an outlet temperature and an inlet temperature of the target heat exchange assembly; and
performing variable-frequency control on the cooling pump station according to at least one of the first outlet temperature or the temperature difference.

6. The cooling method according to claim 5, wherein the performing variable-frequency control on the cooling pump station according to at least one of the first outlet temperature or the temperature difference comprises:
in response to the first outlet temperature being greater than or equal to a first threshold, controlling the cooling pump station to operate at a second frequency, the second frequency being greater than the first frequency;
in response to the first outlet temperature being less than the first threshold and the temperature difference being greater than or equal to a second threshold, controlling the cooling pump station to operate at the second frequency; and
in response to the temperature difference being less than the second threshold and the first outlet temperature being less than a third threshold, controlling the cooling pump station to operate at a third frequency, the third frequency being less than the first frequency.

7. The cooling method according to claim 5, wherein the cooling method further comprises:
acquiring a temperature parameter of a target object while the cooling pump station is operating at a first frequency, wherein the temperature parameter of the target object includes at least one of a temperature of a generator winding, a temperature rise of the generator winding, an oil pool temperature of a gearbox, a bearing temperature of the gearbox, or an oil temperature of a transformer; and
in response to the temperature parameter of the target object satisfying an enhanced cooling condition, controlling the cooling pump station to operate at a fourth frequency, the fourth frequency being greater than the first frequency.

8. The cooling method according to claim 5, wherein the cooling method further comprises:
in response to the wind turbine generator system being started, determining whether a heating request of a converter is received;
in response to not receiving the heating request of the converter, controlling the cooling pump station to operate at the first frequency;
in response to receiving the heating request of the converter, acquiring an ambient temperature of the wind turbine generator system at a current moment and an outlet temperature parameter of a generator within a preset duration;
controlling a three-way valve to switch to an internal circulation circuit, the internal circulation circuit being a portion of the cooling circuit excluding a radiator; and
performing opening-degree control on the three-way valve according to the ambient temperature and the outlet temperature parameter of the generator within the preset duration, so as to adjust a temperature of a cooling medium in the internal circulation circuit.

9. The cooling method according to claim 8, wherein the outlet temperature parameter of the generator within the preset duration includes a second outlet temperature of the generator at the current moment and an outlet temperature difference of the generator at the current moment and a moment preceding the current moment; and
the performing opening-degree control on the three-way valve according to the ambient temperature and the outlet temperature parameter of the generator within the preset duration, so as to adjust a temperature of a cooling medium in the internal circulation circuit, comprises:
in response to the ambient temperature being less than a first temperature threshold, the second outlet temperature being greater than a second temperature threshold, and the outlet temperature difference being greater than or equal to a third temperature threshold, controlling the three-way valve to operate at a first opening degree;
in response to the ambient temperature being greater than or equal to the first temperature threshold and less than a fourth temperature threshold, and the outlet temperature difference being greater than or equal to a fifth temperature threshold, controlling the three-way valve to operate at a second opening degree; and
in response to the ambient temperature being greater than or equal to the fourth temperature threshold, and the outlet temperature difference being greater than or equal to a sixth temperature threshold, controlling the three-way valve to operate at a third opening degree,
wherein the first opening degree, the second opening degree, and the third opening degree sequentially increase.

10. The cooling method according to claim 8, wherein after performing opening-degree control on the three-way valve according to the ambient temperature and the outlet temperature parameter of the generator within the preset duration so as to adjust the temperature of the cooling medium in the internal circulation circuit, the cooling method further comprises:
in response to a heater of the cooling pump station starting and the cooling pump station operating at a fifth frequency, performing variable-frequency control on the cooling pump station according to at least one of whether the heating request is eliminated or an outlet temperature of the generator, the fifth frequency being greater than the first frequency.

11. The cooling method according to claim 10, wherein the performing variable-frequency control on the cooling pump station according to at least one of whether the heating request is eliminated or an outlet temperature of the generator comprises:
in response to the heating request being eliminated, controlling the heater to be turned off, and switching an operating frequency of the cooling pump station from the fifth frequency to the first frequency; and
in response to the heating request not being eliminated and the outlet temperature of the generator being greater than a first threshold, controlling the heater to be turned off, and in response to the outlet temperature of the generator being greater than a second threshold and the heating request being eliminated, switching the operating frequency of the cooling pump station from the fifth frequency to the first frequency.

12. A cooling apparatus for a wind turbine generator system, the cooling apparatus comprising:
an acquisition module, configured to acquire a first outlet temperature of a cooling pump station and a temperature difference of a target heat exchange assembly while the cooling pump station is operating at a first frequency, wherein the target heat exchange assembly is at least one of N heat exchange assemblies, and the temperature difference is a difference between an outlet temperature and an inlet temperature of the target heat exchange assembly; and
a control module, configured to perform variable-frequency control on the cooling pump station according to at least one of the first outlet temperature or the temperature difference.

13. An electronic device, comprising:
a processor; and
a memory, configured to store computer program instructions,
wherein the computer program instructions, when executed by the processor, cause the method according to any one of claims 5 to 11 to be implemented.

14. A computer-readable storage medium, storing computer program instructions thereon, wherein the computer program instructions, when executed by a processor, cause the method according to any one of claims 5 to 11 to be implemented.
